# EUROPEAN PATENT SPECIFICATION

(11) **EP 0 506 170 B1**
(45) Date of publication and mention of the grant of the patent: **08.09.1999**
(21) Application number: 92200748.9
(22) Date of filing: 17.03.1992
(51) Int. Cl.: H01L 27/07, H01L 21/22

(54) **Integrated structure of bipolar power device with high current density and fast diode and related manufacturing process**
Integrierte Struktur einer bipolaren Leistungsanordnung mit hoher Stromdichte und einer schnellen Diode und Verfahren zu ihrer Herstellung
Structure integrée comprenant un dispositif bipolaire de puissance à haute densité de courant et une diode rapide et son procédé de fabrication

(30) Priority: 28.03.1991 IT MI910836
(43) Date of publication of application: 30.09.1992
(73) Proprietor: Consorzio per la Ricerca sulla Microelettronica nel Mezzogiorno, 95121 Catania (IT); STMicroelectronics S.r.l., 20041 Agrate Brianza (Milano) (IT)
(72) Inventor: Frisina Ferruccio, I-95123 Catania (IT); Ferla, Giuseppe, I-95126 Catania (IT)
(74) Representative: Mittler, Enrico

(56) References cited:
- DE-A- 1 619 972
- DE-A- 3 331 631
- US-A- 3 645 808
- PATENT ABSTRACTS OF JAPAN vol. 5, no. 192 (E-85)8 December 1981 & JP-A-56 114 367 ( TOSHIBA K.K. ) 8 September 1981

## Description

The present invention relates to an integrated structure of bipolar power device with high current density and fast diode and related manufacturing process.

In bipolar devices the lifetime of minority carriers strongly influences both the static characteristics (current capacity) and the dynamic characteristics (switching times, energy loss per cycle).

As far as static characteristics are concerned, it is in fact known that for bipolar transistors the current capacity is determined by the profiles of base and emitter (emitter efficiency), by the thickness of the collector and by the lifetime of minority carriers in the area of the base that is effectively active.

For example, for devices at high-voltage (higher than or equal to 400 volts) the large thickness of the collector require the presence of minority carriers with very high lifetimes to prevent the same carriers from recombining along the crossing of the effective base.

For the same purpose appropriate «gettering» techniques are used (for absorbing metallic impurities), so as to obtain, at the end of all the high-temperature thermal processes, high values of the lifetime of the minority carriers. The effectiveness of these techniques is basic for the manufacture of high-voltage power transistors.

As far as dynamic characteristics are concerned, it is known that the planar technology used for the manufacture of bipolar power devices allows the integration, without any change of the manufacturing process, of a diode between collector and emitter.

Such a diode, generally manufactured under the emitter contact area, that is, under the emitter metallization, has a breakdown voltage equal to the power transistor's emitter-collector breakdown voltage and very high inverted recovery times, ranging from 500 to 1000 nsec, due to the high lifetime of the minority carriers. This causes large losses during the transistor's triggering and limits its use to high frequencies (tens or hundreds of KHz).

In some power applications, such as, say, motor control, there is the need of using diodes having low inverted recovery times (ranging from 100 to 200 nsec), that is fast diodes, that can be obtained only with low lifetimes of the minority carriers (ranging from 0.5 to 1 µsec).

Naturally such lifetimes are incompatible with those necessary for a high current capacity of the power transistor.

Thus the state of the art does not allow the integration of fast diodes in bipolar power structures without strongly jeopardizing its static output characteristics. Currently, for applications requiring them, external diodes are used.

In JP-A-56114367 a structure is disclosed comprising a bipolar transistor and a fast diode, obtained in a single semiconductor chip. The fast diode is isolated from the bipolar transistor of a prescribed distance, and contains dopants suitable to reduce the minority carrier lifetime. In US-A-3645808 a method for selectively diffusing gold into a silicon substrate is disclosed the method providing for forming a diffusion region of a material preventing gold diffusion into the substrate laterally around a circuit element which must have a high switching speed.

The object of the present invention is to allow the manufacture of a single integrated structure comprising a bipolar power device and a fast diode, in which the bipolar device is characterized by a high current density during the conduction step and low switching losses during the triggering step and that can thus be used in particular applications such as motor control.

According to the invention such object is attained with an integrated structure of bipolar power device and fast diode as recited in claim 1.

According to the invention there is also accomplished a process for the manufacture of said structure as defined in claim 5.

The features of the present invention shall be made more evident by the following detailed description of its embodiments, illustrated as a non-limiting example in the enclosed drawings, wherein:
Fig.s 1-4 illustrate successive process steps for the manufacture of an integrated structure according to the invention;
Fig. 5 is a top plan view of the structure of Fig. 2, the latter being a cross-sectional view taken along the line II-II of Fig. 5;
Fig. 6 is a cross-sectional view taken along the line VI-VI of Fig. 5;
Fig.s 7 and 8 illustrate the curves of the coefficients of vertical and surface diffusion of gold ions in silicon and of the coefficient of segregation of gold in silicon as a function of temperature;
Fig.s 9-11 illustrate process steps that are alternative to those illustrated in Fig.s 1-4 for another embodiment of the integrated structure according to the invention.

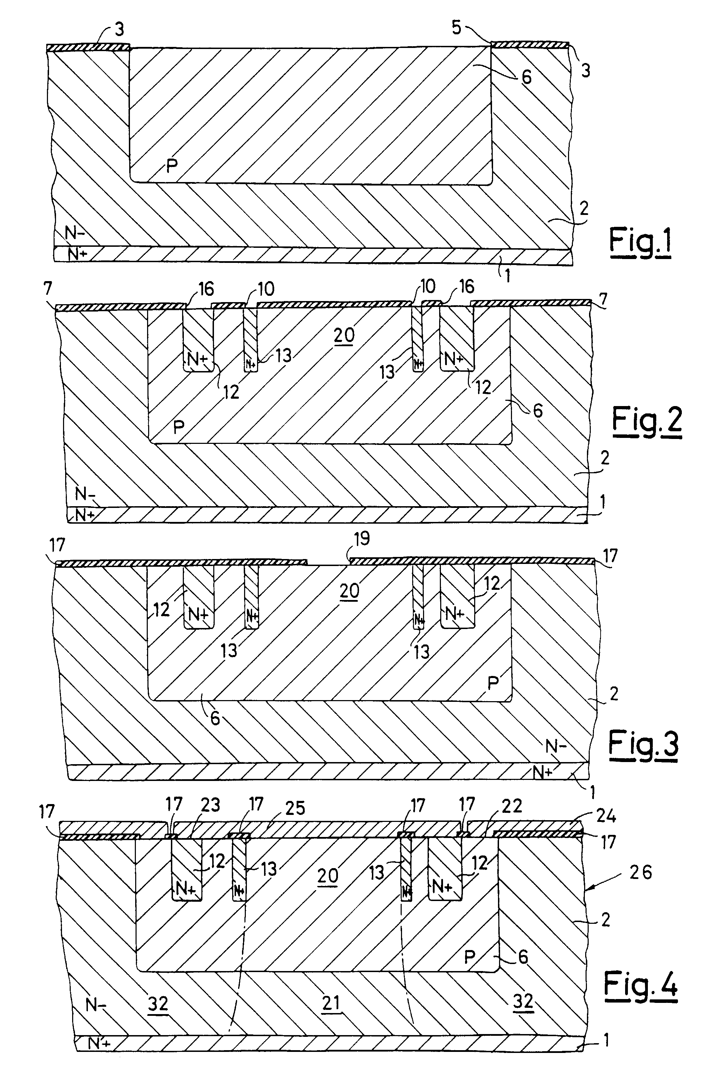

With reference to Fig. 1, on a silicon chip constituting a substrate 1 of the type N+ there is grown an epitaxial layer 2 of the type N- with a low concentration of dopant. Such layer 2 is necessary for keeping voltage in power devices with a breakdown voltage ranging from 100 to 1000 volts. The resistivity of the epitaxial layer 2 varies from 5 to 100 ohm/cm and the thicknesses from 5 to 100 µm.

On this epitaxial layer 2 there is formed a layer of oxide 3, which after appropriate masking is subsequently etched so as to define a window 5 providing access to the epitaxial layer 2. Inside the window 5 there is then accomplished an implantation of ions of the type P, say, boron, and their subsequent diffusion at high temperature the base region 6 of a bipolar power transistor of the type NPN, whose collector is constituted by the substrate 1.

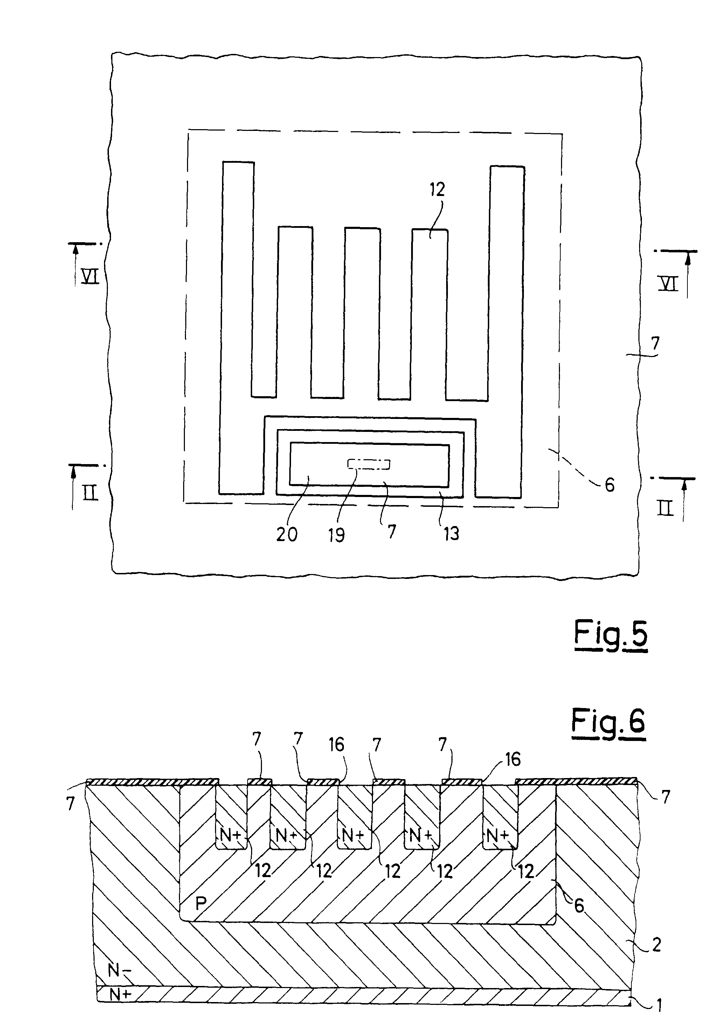

With reference to Fig. 2, on the surface of the device there is subsequently formed a layer of oxide 7, which after appopriate masking is then etched in such a way as to define a comb-like window 16, clearly seen in Fig.s 5 and 6, giving access to the base region 6 and an annular window 10 above the base region 6 outside the window 16 (Fig. 5). Through the windows 16 and 10 there is then accomplished through the implantation of ions of the type N+, say, arsenic, and their subsequent diffusion an emitter region 12 of the bipolar NPN transistor and an annular region 13. The comb-like surface extension of the emitter region 12 allows the optimization of the current distribution.

Inside the annular region 13 there is defined a portion 20 of the base region 6, having an area ranging from (200x200)µm² and (1000x1000)µm², suitable for constituting the anode region of a fast PN diode to be integrated in the bipolar power device.

When the high-temperature thermal processes have come to an end a process of absorption of impurities is then carried out in the entire structure with the purpose of increasing the lifetime of the minority carriers and thus the current capacity of the power device.

At this point, as shown in Fig. 3, the surface of the integrated structure is coated with a layer of oxide 17 which, after appropriate masking, is subsequently etched so as to define a window 19 giving access to the portion 20. The window 19 has dimensions ranging from (50x50)µm² and (300x300)µm² and is located in the centre of the diode area surrounded by the annular region 13 (Fig. 5). There follows an implantation, in the portion 20, through the window 19, of gold ions, or, as an alternative, of platinum ions, in an amount selected between 1x10¹² and 1x10¹⁵ atoms/cm², and their subsequent diffusion at low temperature (ranging from 750 to 900°C) in the same portion 20 and in an underlying portion 21 of the epitaxial layer 2 down to the substrate 1, which constitutes the cathode region of the fast diode.

It is known that gold and platinum diffuse in silicon through the migration of interstitial atoms that can pass in a substitutional position of the silicon atoms according to the known «kick-out» mechanism.

The implantation of gold or platinum ions in silicon may be accomplished, say, by using the device for the ionization of metals having a high melting point, which may be used on ionic implanters of the type using ion sources of the Freeman type or similar.

The amount and the temperature of implantation of gold in silicon are selected so as to ensure that the gold ions diffuse vertically until they reach the substrate 1, but are wholly contained laterally in the portions 20, 21 inside the annular region 13.

In particular the amount of implant and the temperature are obtained taking into account the values of some characteristic parameters such as the coefficients of vertical and horizontal diffusion and the coefficient of segregation of gold in silicon.

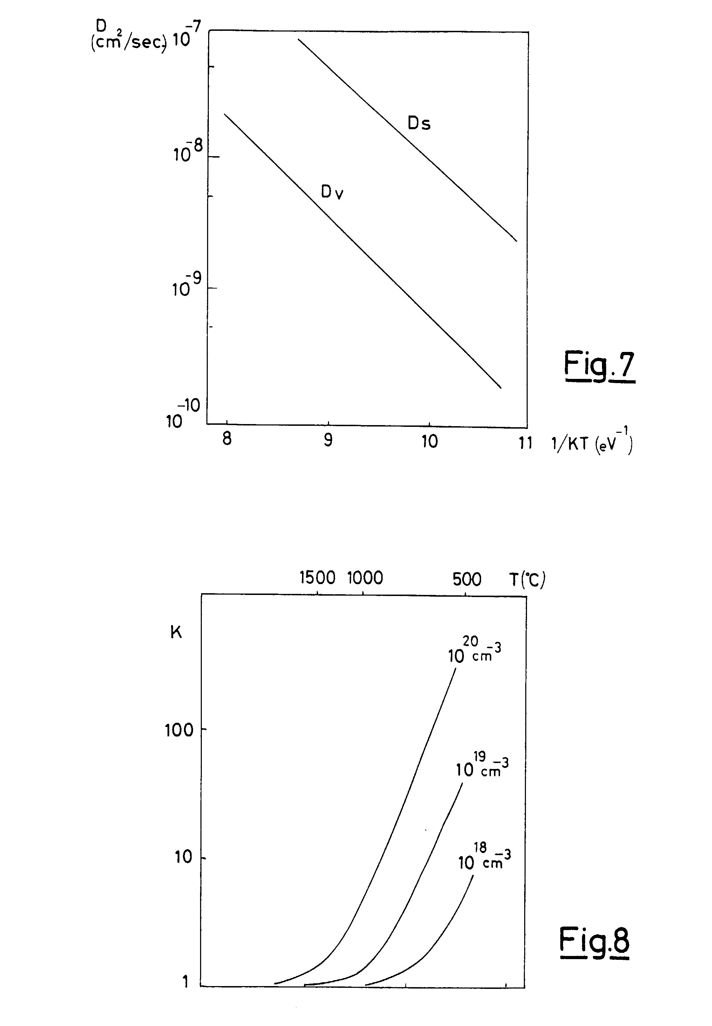

With reference to Fig. 7, this illustrates the curve of the coefficient of vertical diffusion Dv and of the coefficient of surface diffusion Ds of gold at different temperatures.

As an example, the coefficient of vertical diffusion of gold in silicon at the temperature of 970°C is about Dv = 10⁻⁹ cm²/sec, while the coefficient of lateral diffusion at the surface of the silicon, due to the different conditions at the border, is appreciably higher, say, some Ds = 10⁻⁸ cm²/sec at the same temperature of 970°C. In addition, the quantity of gold or platinum introduced into the silicon is distributed in relation to the concentration of dopant in the silicon.

With reference to Fig. 8, it is shown that the curve of the coefficient of segregation K of gold in silicon, defined as the ratio between the concentration of gold in the more highly-doped silicon and the concentration of gold in the less highly-doped silicon is strongly influenced by the temperature of diffusion and the concentration of silicon.

For equal concentrations of dopant in the silicon the coefficient of segregation rises with the fall of the temperature; at constant temperature it rises with the increase of the concentration of the dopant itself.

It follows that, if a low temperature of diffusion of the gold in the silicon is used, as soon as the gold atoms reach the internal wall of the annular region 13, due to the latter's high coefficient of segregation, they are stopped at the surface.

The connection between the depth of diffusion represented by the thickness of the epitaxial layer 2 (ranging from 20 to 100 µm) and the horizontal distance of diffusion constituted by the larger side of the under-region 20 defined inside the annular region 13 (ranging from 200 to 1000 µm) depends on the dimension of the window 19 and on the ratio between the vertical and horizontal coefficients of diffusion.

With reference to Fig. 4, after implantation and subsequent diffusion of gold or platinum in the portions 20, 21, the oxide 17 is partially removed, which remains positioned on the surface of the integrated structure at the annular region 13 and on the sides of areas in which the contacts of base 22 and of emitter 23 are fabricated. There are then deposited the corresponding metallizations of base 24 and of emitter 25. The recoating of the annular region 13 causes the latter to be no longer contacted by the metallization 25. The metallization 25, on the other hand, contacts the base portion 20 forming a fast integrated diode between the emitter 12 and the collector 1.

In this way, as can be seen from Fig. 4, two distinct areas have been manufactured inside the same device 26:
one area reserved for the fast diode, constituted by the portions 20, 21, circumscribed by the dotted lines, wherein gold or platinum have been diffused and which is characterized by a short lifetime of the minority carriers (say, 1 psec or less);
the rest of the semiconductor chip, indicated generacally with 32, where there has been manufactured an NPN bipolar power transistor with high lifetimes (say, some 10 µsec or more) of the minority carriers determined by the gettering process.

The process described above for the manufacture of the structure of Fig. 4 can also be used for the manufacture of a structure wherein a transistor is necessary that has a high lifetime of the minority carriers (equal to some 10 µsec or more) and a diode with several areas having a low lifetime of the minority carriers (equal to some 1 psec or less).

In such case, starting from the situation illustrated in Fig. 1, that is, from a substrate 1 of the type N+ on a which there has been grown an epitaxial layer 2 of the type N- having a low concentration, on which there has in turn been formed an oxide 3, through a window 5 of which an implantation of boron has been executed and its subsequent diffusion at high temperature manufacturing a base region 6 of the type P, there are then followed the process steps illustrated in Fig.s 9, 10 and 11.

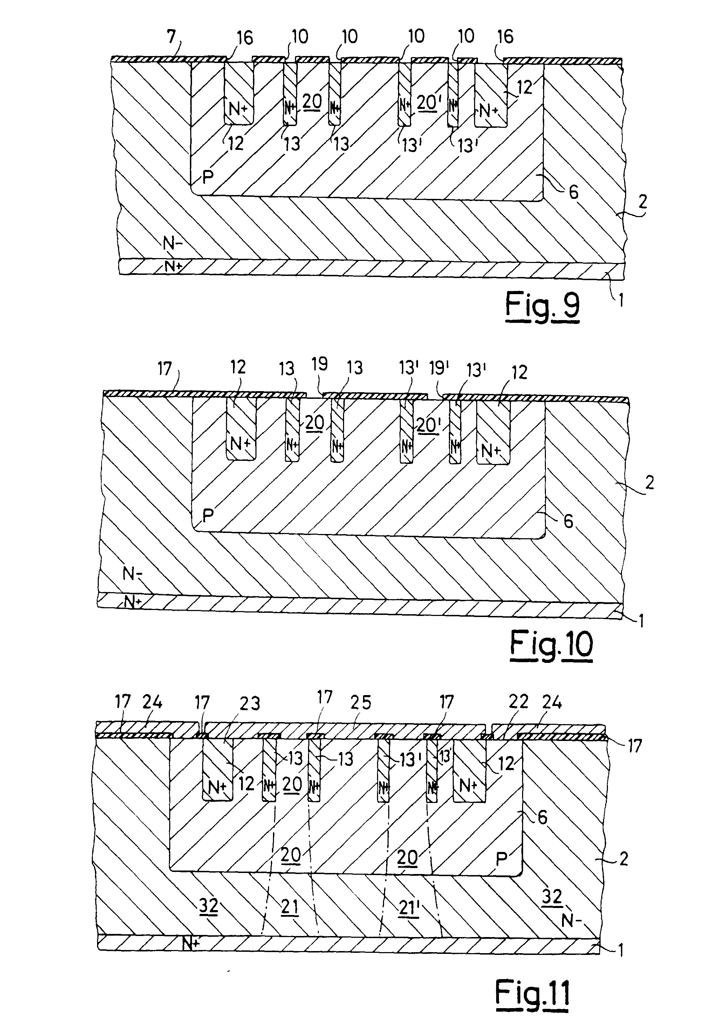

With reference to Fig. 9, between the emitter regions 12 there are created, instead of one, several annular regions 13, 13' suitable for defining inside them several portions 20, 20' of the base region 6.

With reference to Fig. 10, on the surface of the device several windows 19, 19' are then manufactured, each located between a corresponding annular region 13, 13'. The dimensions of the windows 19, 19' are calculated as above in relation to the larger dimension of each annular region 13, 13' to the thickness of the epitaxial layer 2 and to the implantation dose and diffusion temperature of gold or platinum.

With reference to Fig. 11 there are lastly manufactured the base 22 and emitter 23 contacts and the base 24 and emitter 25 metallizations are deposited.

There has thus been obtained a bipolar power device with a high lifetime of the minority carriers, together with which, between the collector and the emitter, there is integrated a diode with several areas having a low lifetime of the minority carriers. This diode allows a better control of the current recovery features during the switching step.

## Claims

1. Integrated structure of bipolar power device with high current density and fast diode formed by a single chip of semiconductor material, comprising a layer (2) of a first conductivity type forming a collector of the bipolar power device, a first diffused region (6) of a second conductivity type formed inside said layer (2) and forming a base region of the bipolar power device, and a second diffused region (12) of the first conductivity type forming an emitter of the bipolar power device formed in said first diffused region (6), the base region (6) and said layer (2) having a high minority carrier lifetime, a base metallization layer (24) contacting the base region, an emitter metallization layer (25) contacting the emitter region, said fast diode comprising at least one portion (20;20,20') of the base region (6) and a respective portion (21;21,21') of said layer (2) below said at least one portion (20;20,20') of the base region (6), characterized in that said at least one portion (20;20,20') of the base region and said respective portion (21;21,21') of said layer (2) are doped with ions suitable for reducing the minority carrier lifetime and have a reduced minority carrier lifetime, and in that said at least one portion (20;20,20') of the base region (6):
- is contacted by the emitter metallization layer;
- is delimited by an annular diffused region (13;13,13') of the first conductivity type which is included in the base region (6);
- said annular region is partially surrounded by the emitter region, such that the annular region is located between opposed portions of the emitter (12).

2. Integrated structure according to claim 1, characterised in that said at least one annular region (13) has a high coefficient of segregation in respect of said ions.

3. Integrated structure according to claim 1, characterised in that inside said base region (6) there are obtained several annular regions (13, 13') circumscribing inside them several respective portions (20, 20') of said base region (6) having respective underlying portions (21, 21') of said layer (2) to constitute corresponding regions having a low lifetime of the minority carriers of said fast diode.

4. Integrated structure according to claim 3, characterised in that said annular regions (13, 13') have a high coefficient of segregation in respect of said ions.

5. Process of manufacturing an integrated structure according to claim 1, comprising the growth of an epitaxial layer (2) having a low concentration of dopant on a substrate (1) of semiconductor material with dopant of the first type, the formation of oxide (3) with the subsequent masking and etching for the definition of a base region (6), the implantation and subsequent diffusion of dopant of the second type in said base region (6), a further formation of oxide (7) with the subsequent masking and etching for the definition of an emitter region (12) and of at least one annular region (13, 13') circumscribing inside it a portion (20, 20') of said base region (6) and partially surrounded by the emitter region, the implantation and subsequent diffusion of dopant of the first type in said emitter region (12) and in said at least one annular region (13, 13'), the absorption of impurities in the entire structure to increase the lifetime of the minority carriers, the implantation inside said portion (20, 20') of the base region (6) of ions suitable for reducing the lifetime of the minority carriers and their subsequent diffusion in depth in an underlying portion (21, 21') of the epitaxial layer (2) and down to the substrate (1), and the formation of a base metallization layer contacting the base and of an emitter metallization layer contacting the emitter and said portion (20,20') of the base region.

6. Process according to claim 5, characterised in that the implantation of said at least one annular region (13, 13') is accomplished so as to determine a high coefficient of segregation in respect of said ions.

7. Process Process according to claim 5, characterised in that said ions are ions of gold.

8. Process according to claim 5, characterised in that said ions are ions of platinum.

## Patentansprüche

1. Integrierte Struktur aus einer bipolaren Leistungsvorrichtung mit hoher Stromdichte und einer schnellen Diode, die durch einen einzigen Chip aus Halbleitermaterial ausgebildet sind, wobei die Struktur folgendes aufweist: eine Schicht (2) eines ersten Leitfähigkeitstyps, die einen Kollektor der bipolaren Leistungsvorrichtung ausbildet, einen ersten diffundierten Bereich (6) eines zweiten Leiffähigkeitstyps, der innerhalb der Schicht (2) ausgebildet ist und einen Basisbereich der bipolaren Leistungsvorrichtung ausbildet, und einen zweiten diffundierten Bereich (12) des ersten Leitfähigkeitstyps, der einen Emitter der im diffundierten Bereich (6) ausgebildeten bipolaren Leistungsvorrichtung ausbildet, wobei der Basisbereich (6) und die Schicht (2) eine hohe Minoritätsträger-Lebensdauer haben, wobei eine Basis-Metallisierungsschicht (24) den Basisbereich kontaktiert, wobei eine Emitter-Metallisierungsschicht (25) den Emitterbereich kontaktiert, wobei die schnelle Diode wenigstens einen Teil (20; 20, 20') des Basisbereichs (6) und einen jeweiligen Teil (21; 21, 21') der Schicht (2) unter dem wenigstens einen Teil (20; 20, 20') des Basisbereichs (6) aufweist, dadurch gekennzeichnet, daß der wenigstens eine Teil (20; 20, 20') des Basisbereichs und der jeweilige Teil (21; 21, 21') der Schicht (2) mit lonen dotiert sind, die zum Reduzieren der Minoritätsträger-Lebensdauer geeignet sind, und eine reduzierte Minoritätsträger-Lebensdauer haben, und daß der eine Teil (20; 20, 20') des Basisbereichs (6):
- durch die Emitter-Metallisierungsschicht kontaktiert ist;
- durch einen ringförmigen diffundierten Bereich (13; 13, 13') des ersten Leitfähigkeitstyps begrenzt ist, der im Basisbereich (6) enthalten ist; und
- der ringförmige Bereich teilweise durch den Emitterbereich umgeben ist, so daß der ringförmige Bereich zwischen gegenüberliegenden Teilen des Emitters (12) angeordnet ist.

2. Integrierte Struktur nach Anspruch 1, dadurch gekennzeichnet, daß der wenigstens eine ringförmige Bereich (13) einen hohen Absonderungskoeffizienten in bezug auf lonen hat.

3. Integrierte Struktur nach Anspruch 1, dadurch gekennzeichnet, daß innerhalb des Basisbereichs (6) mehrere ringförmige Bereiche (13,13') erhalten werden, die in ihnen mehrere jeweilige Teile (20, 20') des Basisbereichs (6) mit jeweiligen darunterliegenden Teilen (21, 21') der Schicht (2) umgeben, um Bereiche mit einer niedrigen Lebensdauer der Minoritätsträger der schnellen Diode bilden.

4. Integrierte Struktur nach Anspruch 3, dadurch gekennzeichnet, daß die ringförmigen Bereiche (13, 13') einen hohen Absonderungskoeffizienten in bezug auf die lonen haben.

5. Verfahren zum Herstellen einer integrierten Struktur nach Anspruch 1, das folgendes aufweist: das Aufwachsen einer Epitaxialschicht (2) mit einer niedrigen Konzentration eines Dotierungsmittels auf einem Substrat (1) aus einem Halbleitermaterial mit einem Dotierungsmittel des ersten Typs, das Ausbilden eines Oxids (3) mit dem darauffolgenden Maskieren und Ätzen für die Definition eines Basisbereichs (6), das Implantieren und das darauffolgende Diffundieren eines Dotierungsmittels des zweiten Typs im Basisbereich (6), ein weiteres Ausbilden von Oxid (7) mit dem darauffolgenden Maskieren und Ätzen für die Definition eines Emitterbereichs (12) und wenigstens eines ringförmigen Bereichs (13, 13'), der innerhalb von ihm einen Teil (20, 20') des Basisbereichs (6) umgibt und teilweise durch den Emitterbereich umgeben ist, das Implantieren und das darauffolgende Diffundieren eines Dotierungsmittels des ersten Typs im Emitterbereich (12) und in dem wenigstens einen ringförmigen Bereich (13, 13'), das Absorbieren von Störstellen in der gesamten Struktur, um die Lebensdauer der Minoritätsträger zu erhöhen, das lmplantieren von lonen innerhalb des Teils (20, 20') des Basisbereichs (6), die zum Reduzieren der Lebensdauer der Minoritätsträger geeignet sind, und ihr darauffolgendes tiefenmäßiges Diffundieren in einem darunterliegenden Teil (21, 21') der Epitaxialschicht (2) und nach unten zum Substrat (1), und das Ausbilden einer Basis-Metallisierungsschicht, die den Emitter und den Teil (20, 20') des Basisbereichs (6) kontaktiert.

6. Verfahren nach Anspruch 5, dadurch gekennzeichnet, daß das Implantieren des wenigstens ringförmigen Bereichs (13, 13') erreicht wird, um einen hohen Koeffizienten einer Absonderung in bezug auf die lonen zu bestimmen.

7. Verfahren nach Anspruch 5, dadurch gekennzeichnet, daß die lonen lonen aus Gold sind.

8. Verfahren nach Anspruch 5, dadurch gekennzeichnet, daß die lonen lonen aus Platin sind.

## Revendications

1. Structure intégrée de dispositif de puissance bipolaire à haute densité de courant et diode rapide formée d'une seule puce de matériau semiconducteur, comprenant une couche (2) d'un premier type de conductivité formant un collecteur du dispositif de puissance bipolaire, une première région diffusée (6) d'un second type de conductivité formée à l'intérieur de ladite couche (2) et formant une région de base du dispositif de puissance bipolaire, et une seconde région diffusée (12) du premier type de conductivité formant un émetteur du dispositif de puissance bipolaire, formé dans ladite première région diffusée (6), la région de base (6) et ladite couche (2) présentant une longue durée de vie des porteurs minoritaires, une couche (24) de métallisation de base en contact avec la région de base, une couche (25) de métallisation d'émetteur en contact avec la région d'émetteur, ladite diode rapide comprenant au moins une partie (20; 20, 20') de la région de base (6) et une partie respective (21; 21, 21') de ladite couche (2) sous ladite partie (20; 20, 20') au nombre d'au moins une de la région de base (6), caractérisée en ce que ladite partie (20; 20, 20') au nombre d'au moins une de la région de base et ladite partie respective (21; 21, 21') de ladite couche (2) sont dopées avec des ions adaptés pour réduire la durée de vie des porteurs minoritaires et présentent une durée de vie des porteurs minoritaires réduite, et en ce que ladite partie (20; 20, 20') au nombre d'au moins une de la région de base (6) :
- est en contact avec la couche de métallisation d'émetteur;
- est délimitée par une région diffusée annulaire (13; 13, 13') du premier type de conductivité qui est incluse dans la région de base (6);
- ladite région annulaire est partiellement entourée par la région d'émetteur, de sorte que la région annulaire est située entre des parties opposées de l'émetteur (12).

2. Structure intégrée selon la revendication 1, caractérisée en ce que ladite région annulaire (13) présente un haut coefficient de ségrégation par rapport auxdits ions.

3. Structure intégrée selon la revendication 1, caractérisée en ce qu'à l'intérieur de ladite région de base (6) sont obtenues plusieurs régions annulaires (13, 13') circonscrivant plusieurs parties respectives (20, 20') de ladite région de base (6) comportant des parties sous-jacentes respectives (21, 21') de ladite couche (2) pour constituer des régions correspondantes présentant une faible durée de vie des porteurs minoritaires de ladite diode rapide.

4. Structure intégrée selon la revendication 3, caractérisée en ce que lesdites régions annulaires (13, 13') présentent un haut coefficient de ségrégation par rapport auxdits ions.

5. Procédé de fabrication d'une structure intégrée selon la revendication 1, comprenant la croissance d'une couche épitaxiale (2) présentant une faible concentration de dopant sur un substrat (1) de matériau semiconducteur avec du dopant du premier type, la formation d'oxyde (3) avec le masquage et l'attaque subséquents pour la définition d'une région de base (6), l'implantation et la diffusion subséquente de dopant du second type dans ladite région de base (6), une formation supplémentaire d'oxyde (7) avec le masquage et l'attaque subséquents pour la définition d'une région d'émetteur (12) et d'au moins une région annulaire (13, 13') circonscrivant une partie (20, 20') de ladite région de base (6), et partiellement entourée par la région d'émetteur, l'implantation et la diffusion subséquente de dopant du premier type dans ladite région d'émetteur (12) et dans ladite région annulaire (13, 13') au nombre d'au moins une, l'absorption d'impuretés dans la structure entière pour accroître la durée de vie de porteurs minoritaires, l'implantation à l'intérieur de ladite partie (20, 20') de la région de base (6) d'ions adaptés pour réduire la durée de vie des porteurs minoritaires et leur diffusion subséquente en profondeur dans une partie sous-jacente (21, 21') de la couche épitaxiale (2) et jusqu'au substrat (1), et la formation d'une couche de métallisation de base en contact avec la base et une couche de métallisation d'émetteur en contact avec l'émetteur et ladite partie (20, 20') de la région de base.

6. Procédé selon la revendication 5, caractérisé en ce que l'implantation de ladite région annulaire (13, 13') au nombre d'au moins une est accomplie de façon à déterminer un haut coefficient de ségrégation par rapport auxdits ions.

7. Procédé selon la revendication 5, caractérisé en ce que lesdits ions sont des ions d'or.

8. Procédé selon la revendication 5, caractérisé en ce que lesdits ions sont des ions de platine.
